(19) **Europäisches Patentamt / European Patent Office / Office européen des brevets**

(11) **EP 2 241 879 A1**

(12) # EUROPEAN PATENT APPLICATION
published in accordance with Art. 153(4) EPC

(43) Date of publication:
**20.10.2010 Bulletin 2010/42**

(21) Application number: **09708078.2**

(22) Date of filing: **04.02.2009**

(51) Int Cl.:
*G01N 22/00* (2006.01)    *G01R 27/26* (2006.01)

(86) International application number:
**PCT/ES2009/000061**

(87) International publication number:
**WO 2009/098336 (13.08.2009 Gazette 2009/33)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **04.02.2008 ES 200800285**

(71) Applicants:
- **Universidad Politecnica De Valencia**
  **46022 Valencia (ES)**
- **Instituto Tecnológico Del Calzado Y Conexas (INESCOP)**
  **03600 Elda, Alicante (ES)**

(72) Inventors:
- **CANON MARIN, Antoni Josep**
  **E-46022 Valencia (ES)**
- **CATALA CIVERA, José Manuel**
  **E-46022 Valencia (ES)**

- **GARCIA BAÑOS, Beatriz**
  **E-46022 Valencia (ES)**
- **LLOBEL ANDRES, Cristina**
  **E-03600 Elda (Alicante) (ES)**
- **MONTIEL PARREÑO, Enrique**
  **E-03600 Elda (Alicante) (ES)**
- **ORGILÉS BARCELÓ, Ángel César**
  **E-03600 Elda (Alicante) (ES)**
- **PEÑARANDA FOIX, Felipe Laureano**
  **E-46022 Valencia (ES)**
- **PORTAS ROSAS, Norberto**
  **E-03600 Elda (Alicante) (ES)**
- **POVEDA VERDU, Damián**
  **E-03600 Elda (Alicante) (ES)**
- **DE LOS REYES DAVÓ, Elías**
  **E-46022 Valencia (ES)**

(74) Representative: **Ungria Lopez, Javier**
  **Avda. Ramón y Cajal, 78**
  **28043 Madrid (ES)**

(54) **METHOD FOR NON-INVASIVE MONITORING OF THE CURING OF A THERMOSTABLE PLASTIC BY MEANS OF THE USE OF MICROWAVES AND MICROWAVE DEVICE FOR IMPLEMENTING SAID METHOD**

(57) **SUMMARY**

The invention refers to a method for the non-invasive monitoring of the chemical reaction linked to the curing process of a thermoset plastic material using microwaves, from the real-time measurements of the reflection coefficient of a resonator sensor using a detector that simultaneously provides modulus and phase values.

The invention also refers to, as an example of the application of the method, a device for the non-invasive determination of the degree of cure of a thermoset plastic material at microwave frequencies.

In another aspect, the invention proposes a method for the determination of the unloaded resonance frequency and the unloaded quality factor of a very strongly coupled microwave resonator and a method for determining the complex permittivity of a material undergoing changes in density, such as those produced during the curing process of polyurethane.

EP 2 241 879 A1

## Description

## FIELD OF THE INVENTION

This invention belongs to the technical field of methods employed to monitor the curing process of a thermoset plastic material. In particular, the invention uses microwaves to obtain readings through which the evolution of the material in the curing process can be monitored.

## BACKGROUND OF THE INVENTION

Curing is a chemical reaction which converts a certain polymer or combination of polymers into a thermoset plastic.

In the case of polyurethane (PUR), curing is based on two basic components, liquids at nearly ambient temperature, which are mixed in specific proportions and react in a mould with a predetermined shape, giving a solid piece. PUR is essentially based on a polyol (known as component A) and a prepolymerised isocyanate (known as component B). As well as the components mentioned, other additives are normally added to the mixture to aid the development of the reaction, such as chain extenders, cross-linking agents, catalysts, blowing agents, light stabilises, anti-static additives, anti-hydrolysers, etc.

From the moment the components are mixed, a more or less simultaneous series of reactions start which give the end result of the thermoset material. Examples of these are polymerisation reactions, cross-linking reactions and foaming reactions. All these reactions take place inside the mould, which acts as a reactor, and once the process is finished the material takes on a thermoset nature which makes further moulding impossible. If during the production process small alterations occur in the dosing or mixture of the components, or even ageing of the components for different causes, the reactions which should be carried out inside the mould may not be those desired, producing a defective material which can not always be detected by sight alone. In some processes, the wasted material can be up to 10%. This has repercussions on additional costs and the environment.

The curing processes for thermoset plastics are generally carried out over a very short time period (in some cases even less than 3 seconds) and are very difficult to control, as they depend on numerous factors such as the dosing of the components, temperature, pressure, humidity, ageing of the components, etc. Because of this, currently the only way of ensuring good quality in thermoset plastics such as polyurcthane is to carry out a series of tests on the material once the curing process has finished - i.e. a posterior controls.

If no monitoring is carried out during the curing process, the process is based on specifications from the polymer manufacturer concerning the time/temperature/pressure recommended, obtained from hypotheses about the state of the materials before/during/after the process. Normally conservative estimations are used, which means that the curing process is much less efficient than it could be.

On some occasions a monitoring system is used based on castling the mixture in special containers which are then analysed destructively in the laboratory, where different parameters directly related to the curing process are determined. This control system allows certain faults to be corrected in time, but has several drawbacks:

- It is destructive
- It only deals with a temporary traction of the reactions produced in the mould
- It requires a temporary suspension of production
- It does not allow for automation of the monitoring process
- It does not provide information about the possible causes of the problem

Procedures are known in the state-of-the-art which allow monitoring of the curing process, the most relevant being those based on temperature sensors (US 6,490,501), ultrasound" (US 5,009,104, US 5,911,159), optical fibre based sensors (US 5,158,720) piezotransducers (us 2006/123914), mass spectrometry (JP 6344366), nuclear magnetic resonance (US 5,321,358) and low frequency microdielectrometry (US 5,158,720).

The temperature sensors are characterised by the fact that they can only monitor exo/endothermic reactions, and the shape, weight and size of samples must be carefully controlled to obtain precise measurements. Moreover, the temperature measurement must be carried out at one point only, generally on the surface, if the process is to be non-invasive.

The drawback of the optical fibre sensors is that they are very fragile and are drastically affected by changes in temperature or pressure, which means that these are not suitable for monitoring the curing of most thermoset plastics, for instance polyurethane.

The functioning of the ultrasound sensors in curing processes is greatly limited by the fact that the used materials absorb much of the signal.

The IR spectrometry, on the other hand, requires the use of destructive methods, as the sensor penetrates and perforates the material to take measurements. It is also very expensive and requires qualified staff.

The present invention describes a new method and a device, as an example of the application of said method, for the non-invasive monitoring of the curing process of a thermoset plastic material. During the evolution of the Changing process associated with curing, changes in viscosity or the hardening of the material also imply dynamic changes in the complex permittivity at microwave frequencies. Therefore, the dynamic non-invasive measurement of the complex permittivity of the material during the change process, or of a parameter directly or indirectly dependent on the complex permittivity, can be used to monitor the curing process.

Techniques have previously been described for the measurement of complex permittivity. Certain techniques for the measurement of complex permittivity in plantar technology stand out, such as microstrip or coplanar circuits, in patents US 5,334,941 and US 6,61'7,861. In document US 5,334,941 a method is described in which the permittivity is obtained through the measurement of the resonance frequency and the quality factor of a planar resonator from closed expressions, based on simple expressions, which does not allow permittivity to be measured with the required degree of repeatability or precision. In document US 6,617,861 another technique is described for the measurement of the dielectric properties of solid materials based on an iterative method in planar circuits, using as a measuring instrument a network analyser or a peak detector to obtain the reflection or transmission modulus. In this way, using iterative methods makes it difficult to follow the rapid reactions in real time. Furthermore, given that only the modulus is used, the resonance frequency and the quality factors measured are not valid for dielectric characterisation, especially when the coupling of a cavity or resonator is very strong, as demonstrated in the detailed description of the present invention. In this case, knowledge of the measurement phase is essential.

## DETAILED DESCRIPTION OF THE INVENTION

Primarily, the present invention relates to a method for non invasive monitoring of the chemical reaction linked to the curing process of a thermoset plastic material through the use of microwaves. This thermoset plastic material could be polyurethane, for example.

According to the invention, this method includes the following stages.

Firstly the polymeric components are poured into a mould for shaping and curing. The components adopt the form of the mould as the curing process progresses, to become a thermoset plastic in the predefined shape of the mould.

Signals are generated on the microwave frequency spectrum, within a frequency range of 300 MHz and 100 GHz, for example, between 1 GHz and 3 GHz.

These microwave signals are conducted towards the material in the mould by means of a resonator sensor device fed by a coupling network and microwave cable so that the thermoset plastic material reflects a part of the signal conducted towards it and absorbs the other part of the conducted signal, depending on the state of the thermoset material at that moment. The resonator sensor is a resonant microwave structure which is in contact with the thermoset plastic material.

The signal reflected by the thermoset plastic material will be received by the same microwave cable. From this reflected signal the reflection coefficient can be obtained, both its modulus and its phase. This reflection coefficient is defined as the relation or quotient between the conducted signal, also known as incident signal, and the reflected signal.

From these values for the reflection coefficient, i.e. the modulus and the phase, the unloaded resonance frequency is determined, as well as the coupling factor and/or the unloaded quality factor. The unloaded values for resonance frequency and quality factor correspond to thesae values for which disturbances in the resonator sensor coupling network have been eliminated, and which represent the real or typical resonance frequency and quality factor of the resonator sensor without distortion due to the effect of the coupling network. The coupling network can disturb the measurements taken of the resonance frequency and the quality factor, and because of this, using directly calculated values without making adjustments can lead to incorrect results if coupling is not taken into account. Using the electromagnetic relationship between the unloaded resonance frequency and quality factor from the resonator sensor, it is possible to determine the value of the complex permittivity of the thermoset material.

With the values obtained in real time, monitoring in real time of the curing process of a thermoset plastic material can be carried out. For this control or monitoring, either the unloaded resonance frequency and quality factor obtained or the real and imaginary parts of the complex permittivity can be used.

In addition, the method of the invention can include a procedure to obtain the complex permittivity of the thermoset material from the previous determination of the unloaded resonance frequency, coupling factor and quality factor extracted from the measurement of the reflection coefficient from a resonator sensor in contact with the thermoset plastic material. This procedure includes the previous numerical obtaining of a relationship between unloaded resonance frequencies and quality factors, which correspond to the specific shape of the resonator sensor, and complex permittivity values of the thermoset plastic material with which the resonator is in contact, covering the possible values of variation of the thermoset plastic materials during its curing process. That is to say, for each combination of thermoset plastic material and resonator sensor, a matrix relating unloaded resonance frequencies and quality factors with complex permittivity values (real and imaginary part) can be created, making it possible to obtain each of these values, the other two being tabulated. In later sections more details will be given about the procedure mentioned here.

As mentioned, the coupling network can produce distortion in the measurement obtained. Because of this, within the process to obtain the complex permittivity of the thermoset material a pre-calibration of the resonator sensor can be carried out using materials of known permittivity and with different coupling networks, strongly and weakly coupled, to determine in all cases the detuning produced by the coupling network. This detuning can be defined as the deviation of the unloaded resonance frequency as compared with the measured resonance frequency, the measured resonance frequency being the frequency at which the smallest peak is produced for the reflection coefficient. A strong coupling is understood as the one that allows the injection of a large quantity of energy to the resonator and therefore, the resonator sensor can be applied to materials with high losses or high conductivities, which however greatly disturb the unloaded resonance frequency of the resonator sensor; a weak coupling is the one that causes little disturbance to the resonator sensor but limits its application to materials with low losses or low conductivities.

This procedure also comprises the measurement in real time of the modulus and the phase of the reflected signal and the reflection coefficient, the real-time obtaining of the unloaded quality factor, the coupling factor and the resonance frequency of the smallest peak from the modulus and the phase of the reflection coefficient. With these values it will be possible to obtain in real time the unloaded resonance frequency from the coupling factor and the pre-calibration carried out of the disturbances of the coupling network. In the same way, with the relationship or matrix obtained it will be possible to determine in real time the values of the complex permittivity taking as starting values the unloaded resonance frequency and the unloaded quality factor.

In a second aspect, the invention relates to a device for non-invasive, real-time monitoring of the chemical reaction linked to the curing process of a thermoset plastic material, i.e. polyurethane, inside a mould using microwaves. This device comprises a resonator sensor, a microwave generator for the generation of a microwave signal connected to the resonator sensor through a microwave cable through which the signal generated circulates, and a circuit for the coupling of energy to the resonator. It also comprises a microwave receptor for the reception of the reflected signal through the same microwave cable, which is separated from the generator's incident signal by a separating network.

According to the invention, the resonators sensor is embedded in the mould, and comprises a coaxial structure, of length proportional to the wavelength of the signal emitted, with a first end that features a metallic wall acting as a short circuit, and the second end is contained within the mould surface. The second end of the resonator sensor adapts to the shape of the inside of the mould and does not change the inside surface of said mould, in other words, the presence of the resonator sensor does not alter the shape of the mould and is able to take non-invasive measurements. The resonator sensor is connected to the microwave generator and the microwave receptor through the first end of the resonator sensor. The second end of the resonator sensor is configured to conduct the microwave signal generated towards the thermoset plastic material. This process whereby the signal is conducted can take place when the resonator sensor is in direct contact with the thermoset plastic material, or when they are situated close enough for the signal to travel from the resonator sensor to the thermoset plastic material without there being contact between the two.

The length of the resonator sensor can be proportional in a integer odd multiple of a quarter of the wavelength of the signal emitted. In other words, the length of the resonator sensor can be, for example, an eight, a quarter or three eighths of the wavelength.

The microwave generator can generate microwave signals at a frequency range from 300 MHz to 100 GHz, for example between 1 GHz and 3 CHz.

In the event that both the signal generated and the signal reflected travel through the same mi.crowave cable, the device can include a separating network to separate both signals and thus ensure that the receptor only receives the reflected signal.

The microwave receptor can comprise an element selected from: a system to measure the modulus and phase of the reflected signal in real time, a calibrated reflectometer with 5 or 6 ports, and a network analyser connected to monitoring software to automatically obtain the resonance frequency and the quality factor of the reflected signal.

The energy coupling circuit can be capacitive or inductive. Likewise, the separating network can comprise a circuit selected from: a divider and an isolator, a divider and a directional coupler, a dual directional coupler and a directional coupler, and an isolator.

Preliminary summary of data previously presented:

Firstly, the invention relates to a method for the non-invasive monitoring of the chemical reaction linked to the curing process of a thermoset plastic material using microwaves.

Secondly, the invention relates to a procedure for the determination of the degree of cure using real-time measurements of the reflection coefficient of a resonator microwave sensor by means of a detector which simultaneously provides modulus and phase values.

In another aspect of the invention, as an example of the application of the method, it relates to a device for the non-invasive determination of the degree of cure undergone by a thermoset plastic material using microwaves.

In another aspect, the invention proposes a method for the determination of the unloaded resonance frequency and the unloaded quality factor of a resonant microwave sensor, with a very strong coupling.

In another aspect, the invention proposes a method for the determination of the complex permittivity of a material undergoing changes in hardness, such as those produced in polymer curing processes, from the 2D interpolation of the unloaded resonance frequencies and quality factors measured and complex permittivity values, both real and imaginary parts, previously obtained by a thorough electromagnetic analysis of the resonator sensor in contact witch a material having a curved surface, adapted to the shape of the mould where the curing takes place.

In another aspect, the invention proposes a procedure through which this characterisation of complex permittivity is carried out in real time whilst the curing process is taking place.

Another object of the invention is to propose a process and device for monitoring complex permittivity, where permittivity does not depend on approximations, closed expressions or iterative methods of related variables.

A further object of the invention is to provide a procedure and device for monitoring the curing process on viscous materials, with different degrees of viscosity.

A further object of the invention is to provide a procedure and device for monitoring the curing process where the material used is polyurethane.

**BRIEF DESCRIPTION OF THE DRAWINGS**

A more complete understanding of the present invention and certain advantages thereof may be acquired by referring to the detailed description in consideration with the accompanying drawings, which form an integral part of the description. This set of drawings illustrates, but is not limited to, the following:

Figure 1 illustrates a flowchart depicting the operation of the device being used to monitor the curing of a thermoset material, according to this invention, in which the basic elements used in the method of the invention can be observed.

Figure 2 illustrates different perspective views of the device as an example of its implementation according to this invention.

Figure 3 illustrates a perspective view of a cross section and a top view of the device according to this invention.

Figure 4 illustrates a graph showing the modulus of the reflection coefficient measured by the resonator sensor in different moments in time, throughout the curing process.

Figure 5 illustrates an electric diagram depicting the equivalent circuit of the resonator sensor, with the coupling circuit used to feed it and the microwave cable.

Figure 6 illustrates a measurement of the reflection of the resonator sensor at one moment during the curing process, where an interpolation is carried out to determine the resonance frequency.

Figure 7 illustrates the deviations in the resonance frequency measured using the minimum of reflection, $f_{min}$, with respect to the unloaded or real resonance frequency of the cavity ($f_u$) according to the type of coupling. Low values of $1/k$ represent strong couplings.

Figure 8 illustrates a graph of the unloaded resonance frequency and quality factor values obtained from the measurement of the signal reflected by the material through the resonator sensor, and constitute a representative curve of the evolution of the curing process.

Figure 9 illustrates a graph with a two dimensional representation of the real part of the complex permittivity as a function of the unloaded real resonance frequency and quality factor obtained from the reflected signal, for an example of a specific sensor which corresponds to the diagrams in Figures 2 and 3.

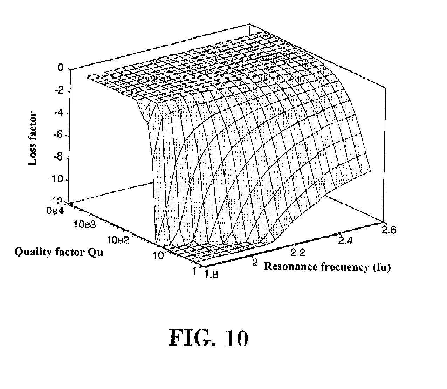

Figure 10 illustrates a graph with two dimensional representation of the imaginary part of the complex permittivity as a function of the unloaded real resonance frequency and quality factor obtained from the reflected signal, for an example of a specific sensor which corresponds to the diagrams in Figure 2 and 3.

Figure 11 illustrates a graph of the value of the real part of the permittivity, the dielectric constant, showing the 2D interpolation procedure to obtain the permittivity value in real time, described in the present invention.

Figure 12 illustrates a graph of the value of the dielectric constant and the loss factor obtained from the measurement of the signal reflected by the material through the resonator sensor, by means of the procedure described in Figure 11, which constitute a second representative curve of the evolution of the curing process.

**PREFERRED EMBODIMENT OF THE INVENTION**

Next, referring to the figures is a description of a preferred embodiment of the method for non-invasive monitoring of the curing of a thermoset plastic material (2) using microwaves and of a microwave device for the application of this method according to the present invention.

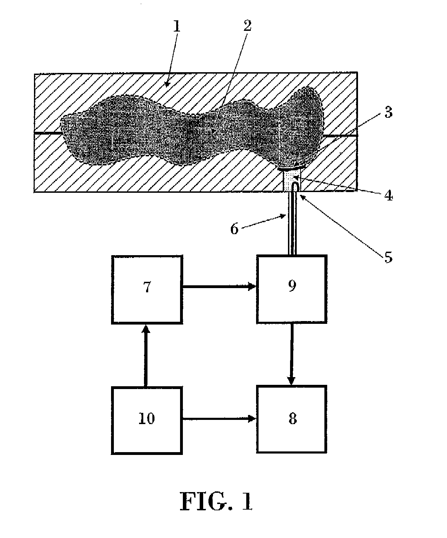

Figure 1 shows an operation scheme for the measurement process of the non-invasive monitoring of the curing of a thermoset plastic material (2). In this figure it can be observed how the thermoset plastic material (2) is placed inside a metallic mould (1). Although the mould (1) is normally metallic, it can also be made of any other material. Once introduced into the mould (1), the polymeric components which will transform into a thermoset plastic material (2) start the curing process, which goes through stages of evolution, modifying its properties and hardening until the mould (1) is filled and it takes on its predefined shape.

In one wall of said mould (1) an access is made and the resonator sensor (4) is placed in contact with the thermoset plastic material (2), without faltering the shape of the inner surface of the mould (1). The contact between the resonator sensor (4) and the thermoset plastic material (2) is such that it permits the resonator sensor (4) to emit microwaves. These waves penetrate the thermoset plastic material (2) where one part is absorbed and the other part reflected and detected by the same resonator sensor (4). If the configuration of the resonator sensor (4) is to modify the inner shape of the mould (1), then a protective covering (3) will be situated. This protective covering (3) must be made from a material that is transparent to microwaves, that is to say that it does not absorb or weaken the energy emitted to the thermoset plastic material (2). Preferred materials for the protective covering (3) are those made from Teflon or ceramics.

In this figure it can also be observed how the resonator sensor (4) which emits microwaves directly to the thermoset plastic material (2) receives the signals coming from the microwave generator (7) through a feeding circuit (5), which is connected to a microwave cable (6). The supply circuit (5) of the resonator sensor (4) is an essential element in the operation of the process, as described in the following figures. This supply circuit (5) can be inductive, implemented with equipment such as current loops or couplings by openings, or capacitive, implemented with electrical probes, for example.

The reflected response from the thermoset plastic material (2) is conducted towards the microwave receptor (8) through the microwave cable (6) through which the signals were initially generated. So that the microwave generator (7) can distinguish the reflected signal from the incident signal, at the end of the microwave cable (6) a separating network (9) is situated, which allows the separation of the reflected signal from the signal emitted by the generator. The microwave receptor (8) consists of a modulus and phase detector, for example of the type AD8302, capable of detecting signals in real time. Commercial network analysers can carry out this function but generally these are not suitable as they present difficulties when worming in real time, being generic devices.

All the signals, both the generation of the microwave signals and the reception of the reflection of the resonator sensor (4) by the microwave receptor (8), are controlled by a control unit (10) responsible for analysing the results of the test. This control unit (10) can carry out the necessary stages to control the correct curing process of a thermoset plastic material (2), for example polyurethane.

This control unit (10) carries out tasks to achieve the constant measurement in real time of the microwaves reflection from the thermoset plastic material (2) provided by the resonator sensor (4) as changes happen due to the chemical reaction linked to the curing process.

The method comprises the following stages:

- The microwave generator (7), as from configuration of the control unit (10), generates signals in the microwave spectrum within a frequency range between 300 MHz and 100 GHz, preferably between 1 MHz and 3 CHz.
- These signals are conducted to the resonator sensor (4) through a microwave cable (6) connected to the supply circuit (5) of the resonator.
- The resonator sensor (4) emits microwaves towards the thermoset plastic material (2), which reflects one part of the signal emitted and absorbs the other part of the signal emitted.
- The reflected signal is detected by the resonator sensor (4) and separated from the incident signal in the microwave cable (6) by a separating network (9).
- Once the reflected and emitted signals are separated, the microwave receptor (8), previously calibrated in the range of frequencies of the microwave generator (7), obtains the modulus and the phase of the ratio between the signal emitted by the generator and the signal reflected, known as the reflection coefficient, $\Gamma_m$.
- Once the reflection coefficient $\Gamma_m$ is determined, the unloaded resonance frequency and unloaded quality factor are obtained from this measurement, according to the procedure that is depicted in the following figures.
- with the input data of the unloaded resonance frequency and the unloaded quality factor, the complex permittivity of the thermoset plastic material (2) can be obtained, although this is not strictly necessary. The changes in the complex permittivity of the thermoset plastic material (2) are the cause of changes in the signal reflected and absorbed by the thermoset plastic material (2), and are the basis for the non-invasive monitoring of the curing process using microwave frequencies.

With the data from the modulus, phase, (unloaded) resonance frequency, (unloaded) quality factor, or complex permittivity, the physical-chemical properties of the thermoset material, i.e. polyurethane or any other tested material, can be obtained from the experimentally obtained correlations, in particular the properties as they change from the base components to the later hard form as a consequence of curing.

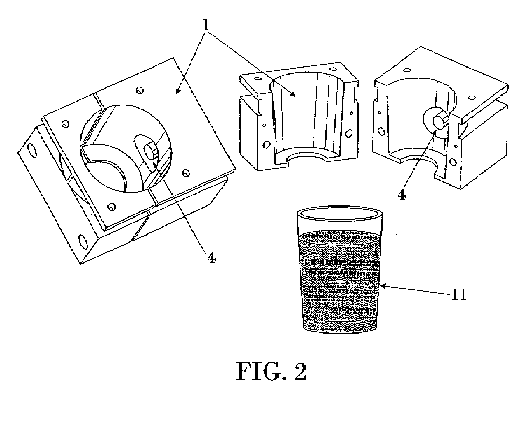

Figure 2 shows a possible embodiment of the resonator sensor (4) for the non-invasive determination of the degree of cure of a thermoset plastic material (2), where the previously described method is applied.

The device comprises a metallic mould (1), a resonator sensor (4) configured as a reflection resonator, and the elements mentioned in the description of figure 1, a microwave generator (7) for the generation of a microwave signal which is transmitted to the resonator sensor (4) through a supply circuit (5) and a microwave cable (6), a separating network (9) and a microwave receptor (8) for reception by the resonator sensor (4) of the modulus and the phase of the reflected signal.

In this example of application, as can be observed in figure 2, the metallic mould (1) where the curing process of the thermoset plastic material (2) is carried out has a truncated-conical or vessel shape.

The resonator sensor (4) is embedded in one of the sides of the mould (1). This resonator sensor (4) is based on a coaxial structure, of a length proportional to the wavelength of the signal emitted, specifically proportional to 1/4, 1/2 or 3/8 of the wavelength. Its inner and outer radial dimensions have been conceived in such a way that the response from the resonator sensor (4) is as sensitive as possible to variations in complex permittivity of the thermoset plastic material (2) in its curing process, as described in the publication; Beatriz García-Baños et al 2005, Meas. Sci. Technol. 16 1186-1192, "Design rules for the optimization of the sensitivity of open-ended coaxial microwave sensors for monitoring changes in dielectric materials".

To monitor the curing process with the instrument described, the polymeric components - for instance, the polyurethane components - are mixed and poured into the mould (1), and from this moment on the real-time reflection from the resonator sensor (4) is received. In this specific case, as shown in figure 2, the configuration of the resonator sensor (4) with an opening in the mould (1) requires a protective covering (3) a few microns thick, to prevent the shape of the thermoset plastic material (2) from being altered by the shape of the resonator sensor (4). An alternative application without the use of this protective covering (3) would be the use of a standard polypropylene vessel (11), this material being transparent to microwaves, with the same inner cross section as the metallic mould (1) into which the polymeric components can be poured and in the interior of which the curing process takes place. The wall of the vessel (11), of a few microns thickness, acts as a protective covering (3) preventing all interference from the resonator sensor (4) on the thermoset plastic material (2), allowing the monitoring process to be carried out non-invasively. Furthermore, the possibility of removing the vessel (11) after each analysis and carrying out a new experiment facilitates the use of the equipment described as a laboratory instrument.

Despite the tact that in figure 2 a coaxial resonator sensor (4) is shown, the configuration of the resonator sensor (4) is not limited to coaxial resonators but can extend to other types of resonators which can adapt to the inner shape of the mould (1), such as for example, special planar sensors such as curved microstrips, curved or straight coplanar sensors, etc., or waveguide sensors with various sections: circular, rectangular, elliptical, etc.

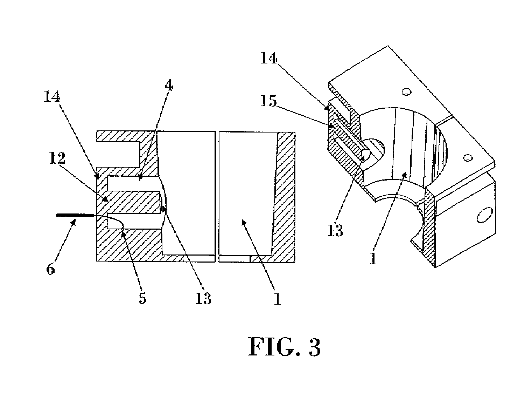

Figure 3 shows detail from the instrument described in figure 2, where it can be seen that the coaxial structure of the resonator sensor (4) comprises two ends (12, 13). The first end (12) features a metallic wall (14) which acts as a short circuit for microwaves and defines their dimensions, as well as the range of frequencies at which it works. Said first end (12) is also used to supply the resonator sensor (4) through a supply circuit (5). The second end (13) is made in such a way that, as can be observed in figures 1 and 3, it adapts to the inner shape of the mould (1) without altering the profile, outline or inner surface of said mould (1).

Following the same procedure described in figure 1, the resonator sensor (4) receives microwaves from the microwave generator (7), in this case preferably between 1 and 3 GHz, through the supply circuit or coupling network (5) and the microwave cable (6), emits them to the thermoset plastic material (2) and collects the response from the thermoset plastic material (2) using the same microwave cable (6). This response manifests itself as a reflection which is received by the microwave receptor (8), after being separated by the separating network (9) from the signal emitted by the microwave generator (7). All this is synchronised by the control unit (10) to carry out control in real time, able to obtain several points per second.

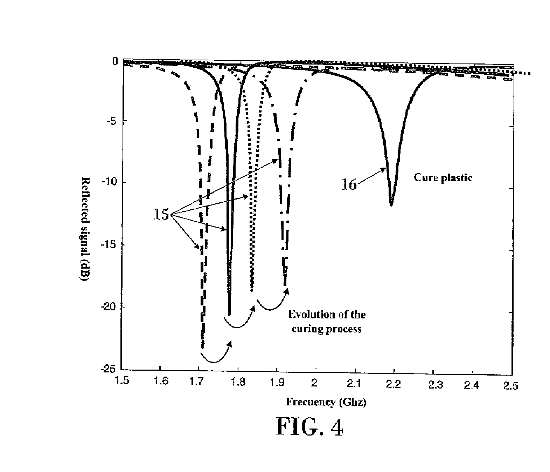

As the curing process progresses, the thermoset plastic material (2) changes its complex permittivity, which in turn changes the reflected signal detected by the resonator sensor (4) and conducted to the microwave receptor (8). Figure 4 shows 5 of these reflected signals, specifically the reflection coefficient $\Gamma_m$, received by the microwave receptor (8) after being separated by a separating network (9) from the signal emitted by the generator, in different moments of the curing process. The different states of the thermoset plastic material (2) during the curing process are represented in this figure by the different signals received. This figure depicts four of the signals received during the curing process (15) and a final signal characterising the thermoset plastic once the curing process is over (16).

Each one of the signals received in figure 4 shows a peak which corresponds to the frequencies absorbed by the thermoset plastic material (2) at that precise moment, known as resonance frequency, while the rest are completely reflected.

In this way, from each of the signals received, a resonance frequency, the one at which reflection is minimal, and a quality factor, associated with the bandwidth of the reflection around the resonance peak, can be extracted. These values can later be used to determine the complex permittivity of the materials. However, this process, described in other patents in the procedure for the determination of complex permittivity with some very specific configurations of resonator sensors and which also requires a high number of discreet points of the frequency response, can lead to serious errors in the final results, as presented below, for which an alternative method is described in this invention.

In general, the connection of a resonator sensor (4) to other external element, such as the microwave generator (7) and the microwave receptor (8) by means of a supply circuit or a coupling network (5) and a microwave cable (6) causes a detuning effect on the resonator sensor (4), therefore the frequency at which the minimum reflection is produced, henceforth referred to as $f_{min}$, does not match the real resonance frequency of the resonator sensor (4), referred to as unloaded resonance frequency and expressed as $f_u$, which is exactly what is related to the complex permittivity of the thermoset plastic material (2). Also, the connection of the resonator sensor (4) with the rest of the elements causes a reduction in the quality factor of the resonance. Thus the whole system presents a quality factor, known as the loaded quality factor and referred to here as $Q_L$, which is related to the bandwidth of the resonance. However this loaded quality factor includes also the effects of elements outside of the resonator sensor (4) and is always lower than the real quality factor presented by the resonator sensor (4) known as unloaded quality factor $Q_u$, which is related to the permittivity of the thermoset plastic material (2). Therefore a procedure is necessary to eliminate the effects of the elements outside of the resonator sensor (4) on the resonance so as to be able to obtain the values for the unloaded resonance frequency and quality factor and to correctly determine the permittivity of the thermoset plastic material (2). This procedure, not carried out in other patents, is implemented in this invention.

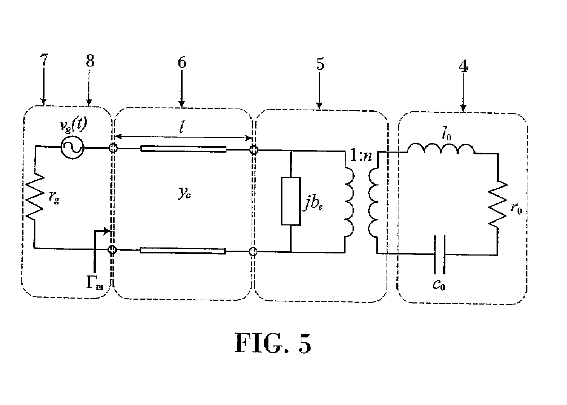

To this end, the electric diagram from Figure 5 is used. Figure 5 depicts a circuit equivalent to the resonator sensor (4), together with the supply circuit (5) used to supply the sensor with the signal coming from the microwave generator (7) through a microwave cable (6), whose reflection is returned through the same microwave cable (6) towards the microwave receptor (8), where it is measured to determine the reflection coefficient, $I_m$.

This electric diagram allows the reduction of the quality factor and the detuning of the resonator sensor (4) to be modelled when connected to the rest of the elements (5, 6, 7, 8), as previously mentioned.

The relation between the loaded quality factor, $Q_L$, of the whole system, and the unloaded quality factor, $Q_U$, specific to the resonator sensor (4), can be obtained using the following formula:

$$Q_L = \frac{Q_u}{1+k} \qquad (\text{i})$$

where $k$ is the coupling coefficient of the supply circuit (5) of the resonator sensor (4) and represents the amount of microwave power which is dissipated in its interior in relation to the power dissipated in the rest of the external elements, in other words, it represents the quantity of energy coupled to the resonator sensor (4).

If the resonator sensor (4) is very weakly coupled, i.e. $k$ is much smaller than 1, the effect of the elements outside the resonator sensor (4) on the resonance can be neglected and the unloaded quality factor, although it will never coincide, can be close to the loaded quality factor and can later be used for the determination of the complex permittivity without any excessive loss of precision. However, if the coupling is not weak, as is necessary, especially at the start of the curing process in thermoset materials, for example, where the material normally presents moderate to high losses and requires strong coupling, the influence of the supply circuit is so important that the use of the value of the loaded quality factor to determine the permittivity would lead to very serious errors.

From expression (i) it is possible to determine the quality factor of the resonator sensor (4), $Q_u$, once the loaded quality factor, $Q_L$, and the coupling factor, $k$, are known. The loaded quality factor, $Q_L$, can be obtained by means of scalar microwave receptors which measure the modulus of the reflection coefficient, $|\Gamma_m|$, such as for example, power detectors. However, the determination of the coupling factor $k$, and consequently the unloaded quality factor, $Q_u$, requires the measurement of the phase of the signal, for which it is necessary to use microwave detectors which provide both the modulus and the phase of the reflection.

The loaded quality factor, $Q_L$, can be obtained from the bandwidth of the reflection around the resonance peak, as carried out in other patents. However, in this invention an alternative procedure is described which offers more precise results. The procedure basically consists of an automatic adjustment of curves on the complex plane of the reflection signal received on the vectorial receptor, $\Gamma_m$, based on the rigorous formulation of the resonant system model shown in Figure 5, and a rapid algorithm to work in real time, which is very important for an industrial application of this type. This new procedure allows:

- A precise, simultaneous, real-time determination of the value of $Q_L$, $k$, $Q_u$ and $f_{min}$, without the need for a high resolution, in other words, without a great number of frequency points, in the detector or from other additional measurements.

- Obtaining of results which are less vulnerable to electronic noise in the measurements.

- Provision of uncertainty values in results associated with electronic noise in the measurements.

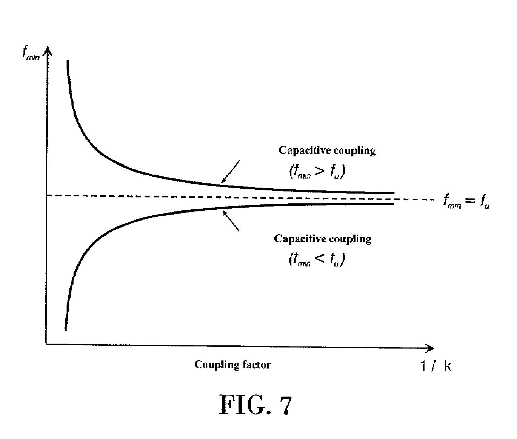

Once these parameters have been obtained, the unloaded or real resonance frequency, $f_u$, of the resonator sensor (4) must be obtained. From the relation depicted in Figure 7, the relation can be established between the resonance frequency which minimises reflection, $f_{min}$, and the unloaded resonance frequency, $f_u$, specific to the resonator sensor (4), using the formula:

$$f_{\min} = f_u\left(1 + \frac{kb_e}{2Q_u}\right) \qquad \text{(ii)}$$

where $b_e$ is the equivalent reactance of the supply circuit (5), which can be inductive, meaning that $b_e$ is greater than zero, or capacitive, meaning that $b_e$ is smaller than zero.

Figure 7 shows the deviations in the resonance frequency measured through the minimum reflection, $f_{\min}$, in relation to the unloaded or real resonance frequency of the cavity, $f_u$, according to the type of coupling.

In the same way as with the quality factors, if the resonator sensor (4) presents weak coupling - $k$ is much smaller than 1 - the equivalent circuit of the supply circuit can be disregarded and the resonance frequency, although it will never coincide, can be close to the minimum of the reflection peak of the resonator sensor (4) and can be used later to determine the complex permittivity without any great loss of precision. In Figure 7 it can be observed that for $k$ values much smaller than 1, which translate to large values for the inverse of $k$, the minimum reflection frequency, $f_{\min}$, is close to the unloaded frequency, $f_u$, However, if the coupling is strong, as is necessary, especially at the start of the curing process of this type of polymeric material, where the material tends to present moderate to high dielectric losses, the influence of the supply circuit is so important that using the minimum reflection frequency to determine the permittivity would lead to serious mistakes.

In principle, once the value for the minimum reflection frequency, $f_{\min}$, is known, the unloaded frequency value, $f_u$, can be obtained using the expression (ii), thereby eliminating the effect of the elements outside the resonator sensor (4) on the resonance frequency. However, the determination of the parameter $b_e$ in (ii) requires exact knowledge of the equivalent length of the microwave cable (6), in other words, value $1$ in Figure 5, which in practice is not possible as the supply circuit (5), sometimes also known as the coupling network, adds extra length to the microwave cable (6) which is, in general, unknown and dependent on the electromagnetic fields inside the resonator sensor (4). Because of this, the previously mentioned curve adjustment procedure does not provide unloaded frequency values, $f_u$, but minimum reflection frequency values, $f_{\min}$.

Therefore, the effect of elements outside the resonator sensor (4) on the resonance frequency is eliminated by means of a pre-calibration in the laboratory with different couplings, with the purpose of determining the exact form of the relation described in Figure 7. This pre-calibration, together with the aforementioned curve adjustment procedure, allows for the real resonance frequency of the resonator, $f_u$, to be later obtained from the measurements of reflection, $\Gamma_m$, in real time, which eliminates the errors or deviations described in previous patents.

The importance of this procedure is greatest when the materials which are measured are thermoset plastic materials (2), owing to the fact that at the beginning of the curing process the polymeric materials present high conductivities or high losses, which forces resonator sensors (4) to be very strongly coupled in order to obtain a correct reading.

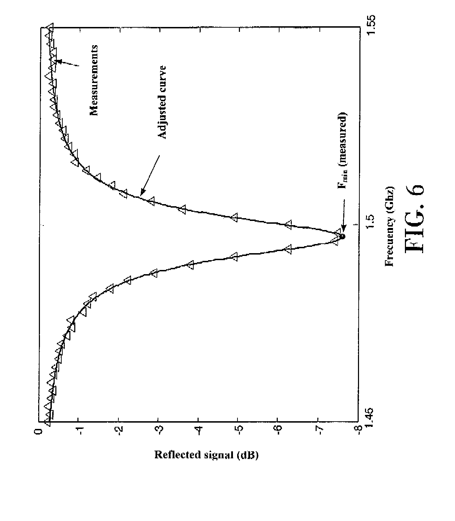

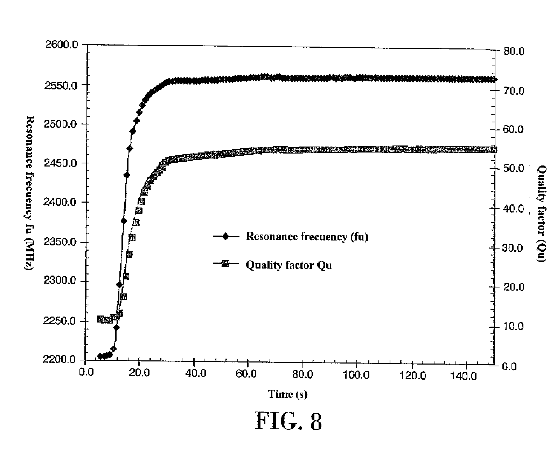

The speed of the microwave generator (7) and the microwave receptor (8) allows several sweeps per second to be obtained, which makes characterisation in real time possible. Figure 8 shows typical evolution of the resonance frequency, $f_u$, and the quality factor, $Q_u$, obtained from the signals shown in figure 4, using the procedure described in figures 5 and 6 and the pre-calibration of figure 7, with the evolution of the curing process, and these constitute a curve representative of the evolution process. It can be seen that after some initial changes, the reading becomes stable, which indicates that the thermoset plastic material (2) has finished the process and will stay stable.

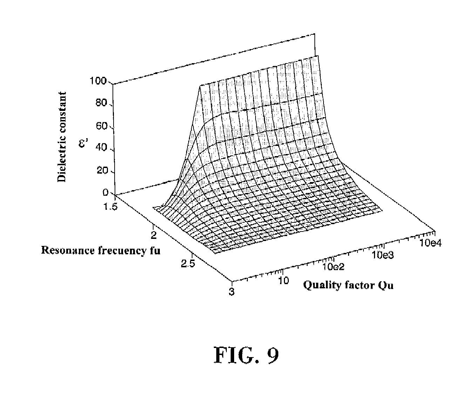

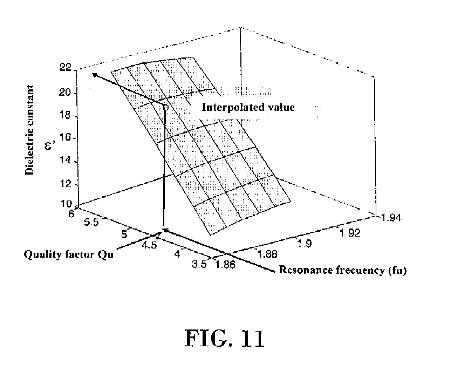

As described, the unloaded resonance frequency and the unloaded quality factor can be used to determine the complex permittivity of thermoset plastic materials (2) and the complex permittivity (real and imaginary parts) can be used as a parameter for monitoring the curing process, although this invention does not refer to a specific method for determining the permittivity. What is proposed in this invention as a data obtaining method for the permittivity in real time, is an alternative to closed expression based on approximations or more rigorous iterative methods, and which essentially consists of the 2D interpolation of previously calculated tables, matrixes, which relate unloaded resonance frequencies and unloaded quality factors to the real and imaginary parts of the permittivity. Figures 9, referring to the real part, and 10, referring to imaginary part, show the value of the matrixes calculated for the configuration of the resonator sensor (4) shown in figures 2 and 3; and figure 11 shows the 2D interpolation process used to determine, for example, the dielectric constant, in other words the real part, from specific measurements of the resonance frequency and the quality factor corresponding to a specific moment during the curing process.

The procedure used to generate the matrixes uses electromagnetic simulators due to the complexity of obtaining these matrixes when the configuration of the end of the resonator sensor (4) in contact with the thermoset plastic material (2) is not regular.

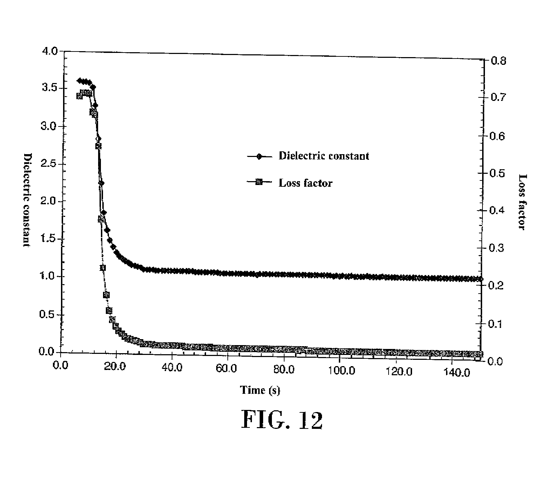

Figure 12 shows the evolution over ti.me of the dielectric constant or real part of the permittivity and the loss factor or imaginary part of the permittivity during the evolution of the curing process of a thermoset plastic material. Said values calculated using the aforementioned procedures, from the measurement of the resonance frequency and the unloaded quality factor, and the 2D interpolation process make their own particular imprint on the monitoring of a specific curing process.

In view of this description and the set of figures, the expert on the subject can understand that the invention has been described according to a preferred embodiment thereof, but that many variations can be introduced within this preferred embodiment without moving away from the object of the invention, as it is claimed.

**Claims**

1. - Method for non-invasive monitoring of then chemical redaction linked to the curing process of a thermoset plastic material (2) using microwaves, **characterised in that** it comprises the stages of:

- placing the thermoset plastic material (2) inside a mould (1) for forming or curing, taking on the shape of the mould (1),
- generating signals in the microwave spectrum within a frequency range of between 300 MHz and 100 GHz,
- conducting these microwave signals towards the thermoset plastic material (2) using a resonator sensor device (4), so that the thermoset plastic material (2) reflects part of the incident signal and absorbs the other part, depending on the state of the thermoset material (2) at that moment,
- receiving the signal reflected by the thermoset plastic material (2) through the response from the resonator sensor (4) and obtaining from the reflected signal the modulus and phase of the reflection coefficient, the reflexion coefficient being the relation between the incident signal and the reflected signal,
- determining the unloaded resonance frequency, the coupling factor and/or the unloaded quality factor from the modulus and phase of the reflection coefficient, the unloaded resonance frequency and the unloaded quality factor being the values in which disturbances from the coupling network (5), also known as the supply circuit of the resonator sensor (4), are eliminated, representing the real resonance frequency and real quality factor of the resonator sensor (4) without taking into account the effect of the coupling network (5),
- determining the complex permittivity of the thermoset material (2) from its electromagnetic relation with the unloaded resonance frequency and the unloaded quality factor of the resonator sensor (4),
- determining the evolution of the curing process of a thermoset material (2) through the real-time monitoring of the unloaded resonance frequency and unloaded quality factor, or through the monitoring of the real and imaginary parts of the complex permittivity.

2. - Method according to claim 1, **characterised in that** it comprises a procedure for obtaining the complex permittivity of the thermoset material (2) from the determination of the unloaded resonance frequency, coupling factor and unloaded quality factor obtained from the measurement of the reflection coefficient of a resonator sensor (4) in contact with the thermoset plastic material (2) through:

- numerical obtaining of pair values ratio that links unloaded resonance frequencies and quality factors, which correspond to the specific shape of the resonator sensor (4), with values for complex permittivity, dielectric constant and loss factor of the thermoset plastic material (2) with which the resonator sensor (4) is in contact, covering possible values for variation of the thermoset plastic material (2) in its curing process.
- pre-calibration of the resonator sensor (4) using materials with a known permittivity and different coupling networks (5), both strong and weak, to determine in all cases the detuning that the coupling network (5) produces, this detuning being understood as the deviation of the unloaded resonance frequency with respect to the measured resonance frequency, where the measured resonance frequency corresponds to the frequency at which the minimum peak of the reflection coefficient is produced,
- real-time measurement of the modulus and the phase of the reflected signal and the reflection coefficient,
- real-time obtaining of the unloaded quality factor, the coupling factor and the resonance frequency $f_{min}$ obtained as the minimum of the reflection coefficient from the modulus and the phase of the reflection coefficient,
- real-time obtaining of the unloaded resonance frequency from the coupling factor and the pre-calibration with the measurement of the reflected signal,
- real-time determination of the values of complex permittivity taking as starting values the unloaded resonance frequency and the unloaded quality factor through the previously obtained pair values ratio for resonance frequencies, unloaded quality factors and the real and imaginary parts of the complex permittivity.

3. - Method according to any of claims 1 or 2, **characterised in that** the microwave signals are generated in real time within a range of frequencies between 1 GHz and 3GHz.

4. - Method according to any of claims 1 to 3, **characterised in that** the thermoset plastic material (2) monitored is polyurethane.

5. - Device for non-invasive real-time monitoring of the chemical reaction linked to the curing process of a thermoset plastic material (2) placed inside a mould (1) using microwaves, which comprises a resonator sensor (4), a microwave generator (7) for the generation of a microwave signal, connected to the resonator sensor (4) by means of a microwave cable (6) through which the signal generated circulates, a circuit or network (5) which couples energy to the resonator and a microwave receptor (8) to receive the signal reflected through the same microwave cable (6) and connected to the resonator sensor (4), **characterised in that**
the resonator sensor (4) is embedded in the mould (1), this resonator sensor (4) comprising a coaxial structure, of a length proportional to the wavelength of the emitted signal, with a first end (12) ending in a metallic wall (14) acting as a short circuit, and a second end (13) contained in the surface of the mould (1), in such a way that the second end (13) of the resonator sensor (4) is adapted to the shape of the inside of the mould (1) and does not modify the surface of the inside of said mould (1) in any way, the resonator sensor (4) being connected to the microwave generator (7) and microwave receptor (8) through its first end (12), and the second end (13) of the resonator sensor (4) configured to conduct the microwave signal generated towards the thermoset plastic material (2).

6. - Device according to claim 5, **characterised in that** the length of the resonator sensor (4) is proportional by an integer odd multiple to a quarter of the wavelength of the emitted signal.

7. - Device according to any of claims 5 or 6, **characterised in that** the microwave generator (7) generates microwave signals in a frequency range between 300 MHz and 100 GHz.

8. - Device according to claim 7, **characterised in that** the microwave generator (7) generates microwave signals in a frequency range between 1 GHz and 3GHz.

9. - Device according to any of claims 5 to 8, **characterised in that** it comprises a separating network (9) to obtain the signal reflected from that conducted by the microwave generator (7), as both signals travel through the same microwave cable (6).

10. - Device according to any of claims 5 to 9, **characterised in that** the microwave receptor (8) comprises an element selected from: a system to measure the modulus and the phase of the reflected signal in real time, a calibrated reflectometer with 5 or 6 ports, and a network analyser connected to a control software to automatically obtain the resonance frequency and quality factor of the reflected signal.

11. - Device according to any of claims 5 to 10, **characterised in that** the energy coupling circuit (5) is the capacitive type.

12. - Device according to any of claims 5 to 10, **characterised in that** the energy coupling circuit (5) is the inductive type.

13. - Device according to any of claims 10 to 12, **characterised in that** the separating network (9) comprises a circuit selected from: a, divider and an isolator, a divider and a directional coupler, a dual directional coupler and a directional coupler, and an isolator.

14. - Device according to any of claims 5 to 13, **characterised in that** the thermoset plastic material (2) is polyurethane.

FIG. 1

FIG. 2

FIG. 3

FIG. 4

FIG. 5

FIG. 6

FIG. 7

FIG. 8

FIG. 9

FIG. 10

FIG. 11

FIG. 12

# INTERNATIONAL SEARCH REPORT

| International application No. |
|---|
| PCT/ ES 2009/000061 |

## A. CLASSIFICATION OF SUBJECT MATTER

see extra sheet

According to International Patent Classification (IPC) or to both national classification and IPC

## B. FIELDS SEARCHED

Minimum documentation searched (classification system followed by classification symbols)

G01N22/00,G01R27/26

Documentation searched other than minimum documentation to the extent that such documents are included in the fields searched

Electronic data base consulted during the international search (name of data base and, where practicable, search terms used)

INVENES, EPODOC, WPI, NPL, XPESP, XPAIP, XPI3E, INSPEC.

## C. DOCUMENTS CONSIDERED TO BE RELEVANT

| Category* | Citation of document, with indication, where appropriate, of the relevant passages | Relevant to claim No. |
|---|---|---|
| X | US 5334941 A (KING) 02.08.1994, the whole document. | 1,3,4,13 |
| Y | | 5-12,14 |
| Y | US 2007210052 A1 (KANECHIKA) 13.09.2007, the whole document. | 5-12,14 |
| X | US 6617861 B1 (JOSHI) 09.09.2003, the whole document. | 1,3,4,13 |
| Y | | 5,6,8-12,14 |
| A | WO 2007129208 A2 (ATS MICROTECH S.R.L.) 15.11.2007, the whole document. | 5 |
| A | US 5227730 A (KING et al.) 13.07.1993, the whole document. | 5 |

☐ Further documents are listed in the continuation of Box C.    ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
|---|---|
| 06 July 2009        (06.07.2009) | **(10/07/09)** |
| Name and mailing address of the ISA/ O.E.P.M. | Authorized officer |
| Paseo de la Castellana, 75 28071 Madrid, España. Facsimile No.   34 91 3495304 | J. Botella Maldonado |
| | Telephone No. +34 91 349 53 82 |

Form PCT/ISA/210 (second sheet) (July 2008)

## INTERNATIONAL SEARCH REPORT

Information on patent family members

International application No.

PCT/ ES 2009/000061

| Patent document cited in the search report | Publication date | Patent family member(s) | Publication date |
|---|---|---|---|
| US 5334941 A | 02.08.1994 | NONE | ------------ |
| US 2007210052 A | 13.09.2007 | JP 2007243423 A | 20.09.2007 20.09.2007 20.09.2007 |
| US 6617861 B | 09.09.2003 | NONE | ------------ |
| WO 2007129208 A | 15.11.2007 | ITMO 20060143 | 08.08.2006 |
| US 5227730 A | 13.07.1993 | NONE | ------------ |

Form PCT/ISA/210 (patent family annex) (July 2008)

| INTERNATIONAL SEARCH REPORT | International application No. |
| --- | --- |
| | PCT/ ES 2009/000061 |

CLASSIFICATION OF SUBJECT MATTER

*G01N 22/00* (2006.01)
*G01R 27/26* (2006.01)

Form PCT/ISA/210 (extra sheeet) (July 2008)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6490501 B
- US 5009104 A
- US 5911159 A
- US 5158720 A
- US 2006123914 A
- JP 6344366 B
- US 5321358 A
- US 5334941 A
- US 6617861 B

**Non-patent literature cited in the description**

- **Beatriz García-Baños et al.** Design rules for the optimization of the sensitivity of open-ended coaxial microwave sensors for monitoring changes in dielectric materials. *Meas. Sci. Technol.,* 2005, vol. 16, 1186-1192